(19) **Europäisches Patentamt**
**European Patent Office**
**Office européen des brevets**

(11) **EP 4 564 028 A1**

(12) **EUROPEAN PATENT APPLICATION**
published in accordance with Art. 153(4) EPC

(43) Date of publication:
04.06.2025 Bulletin 2025/23

(51) International Patent Classification (IPC):
$G01R\ 31/367$ *(2019.01)*  $\quad$ $G01R\ 31/36$ *(2020.01)*
$G01R\ 31/396$ *(2019.01)* $\quad$ $G01R\ 31/388$ *(2019.01)*

(21) Application number: 23939203.8

(22) Date of filing: 22.09.2023

(86) International application number:
PCT/CN2023/120810

(87) International publication number:
WO 2024/244229 (05.12.2024 Gazette 2024/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.05.2023 CN 202310640947

(71) Applicant: Deepal Automobile Technology Co.,
Ltd.
Chongqing 401133 (CN)

(72) Inventors:
• LI, Dongjiang
  Chongqing 401135 (CN)
• LI, Zonghua
  Chongqing 401135 (CN)

(74) Representative: EGLI-EUROPEAN PATENT
ATTORNEYS
Giesshübelstrasse 62
8045 Zürich (CH)

(54) **ESTIMATION METHOD AND APPARATUS FOR SOC OF BATTERY CELL, AND SERVER AND STORAGE MEDIUM**

(57)  The present application relates to the technical field of calculation of the State of Charge (SOC) of battery cells, and in particular to an estimation method and apparatus for an SOC of a battery cell, and a server and a storage medium. The method comprises: acquiring actual charging data of a battery cell within one or more SOC intervals; according to the actual charging data within each SOC interval, generating an actual charging voltage curve of the corresponding SOC interval, querying a pre-established voltage feature database by using each SOC interval as an index, and outputting a reference charging voltage curve of each SOC interval; and calculating the actual capacity and initial SOC of the battery cell according to the actual charging voltage curve and reference charging voltage curve of each SOC interval, and according to the actual capacity and the initial SOC, calculating the actual SOC of the battery cell during charging. In this way, the problems in the prior art of SOC calculation methods being impossible to be applied to multiple battery systems, the calculation effect failing to achieve the expectation and the calculation accuracy being low are solved.

Obtain actual charging data of the battery cell within one or more SOC intervals — S101

Generate an actual charging voltage curve of each of the one or more SOC intervals based on the actual charging data within each of the one or more SOC intervals, and query a pre-established voltage feature database using each of the one or more SOC intervals as an index to output a reference charging voltage curve of each of the one or more SOC intervals — S102

Calculate an actual capacity and an initial SOC of the battery cell based on the actual charging voltage curve and the reference charging voltage curve of each of the one or more SOC intervals, and calculate an actual SOC of the battery cell during charging using the actual capacity and the initial SOC — S103

FIG. 1

**Description**

## CROSS-REFERENCE TO RELATED APPLICATION

This application is based on and claims priority to Chinese patent application No. 202310640947.8 filed on May 31, 2023, the entire contents of which are incorporated herein by reference.

## TECHNICAL FIELD

The present disclosure relates to the field of technology for calculating a State of Charge, SOC, of a battery cell, and in particular to a method and apparatus for estimating a SOC of a battery cell, a server, and a storage medium.

## BACKGROUND

A SOC of a battery is a most critical status parameter of the battery. In a Battery Management System, BMS, the SOC is used to control a charging current, consume power, and to estimate a remaining mileage, which is a fundamental parameter ensuring a normal and safe operation of the battery. The SOC can be defined in many ways. For example, there may be a SOC of positive and negative electrodes defined based on a stoichiometric ratio of the positive and negative electrodes, or a SOC of a battery defined based on a proportion of remaining available lithium ions. In BMS calculations, the SOC of the battery includes different values such as a true SOC, an apparent SOC, and a displayed SOC. These different SOC values have distinct definitions and calculation methods. Specifically, the true SOC refers to a ratio of an actual number of remaining lithium ions inside the battery, which is affected only by temperature and aging state and is not affected by a usage condition. The apparent SOC is related to a dynamic voltage of the battery and affected by environmental temperature, charging/discharging currents, and other operation conditions. Distinguishing and accurately calculating these two types of SOC is crucial for describing a true state of the battery and achieving effective BMS management.

Typically, the SOC obtained from an Open Circuit Voltage, OCV, lookup table represents the true SOC, while the SOC calculated based on a condition of the dynamic voltage represents the apparent SOC. There are several methods for calculating the SOC of the battery, including Coulomb counting (or Ampere-hour integration) method, Static OCV lookup table method, and Kalman filter method. In the related art, a method for obtaining the SOC through an OCV curve lookup table during an idle state is introduced. Coulomb counting method is constrained by an accuracy of a current sensor, with errors accumulating over time. The OCV lookup table method is used in demanding scenarios, especially in a low-temperature environment, necessitating a relatively long standing duration before use. Moreover, for a Lithium Iron Phosphate, LFP or LiFePO4, battery, a voltage platform makes the OCV lookup table method impractical. The Kalman filter method still faces an issue of algorithm divergence, particularly in a LFP voltage platform region, which prevents normal use of the Kalman filter method. For example, in the related art, an extended Kalman filter method is introduced, which adds a particle algorithm-based optimization objective to a conventional Kalman filtering algorithm. This method can optimize noise through the optimization objective during an offline scenario, which improves an accuracy and a calculation speed of a method for calculating the SOC. However, this method is only applicable to a Nickel-Manganese-Cobalt, NMC, system. For a LFP system, this algorithm falls far short of expectations in terms of calculation performance.

## SUMMARY

The present disclosure provides a method and apparatus for estimating a SOC of a battery cell, a server, and a storage medium, to solve problems in the related art such as a failure to meet expectations in terms of calculation performance and a low calculation accuracy due to a fact that a method for calculating a SOC cannot be applied to a wide range of battery systems.

In a first aspect, a method for estimating a SOC of a battery cell is provided according to an embodiment of the present disclosure. The method is applied in a server and includes: obtaining actual charging data of the battery cell within one or more SOC intervals; generating an actual charging voltage curve of each of the one or more SOC intervals based on the actual charging data within each of the one or more SOC intervals, and querying a pre-established voltage feature database using each of the one or more SOC intervals as an index to output a reference charging voltage curve of each of the one or more SOC intervals; and calculating an actual capacity and an initial SOC of the battery cell based on the actual charging voltage curve and the reference charging voltage curve of each of the one or more SOC intervals, and calculating an actual SOC of the battery cell during charging using the actual capacity and the initial SOC.

According to embodiments of the present disclosure, with the above technical means, the actual capacity and an initial SOC of the battery cell can be accurately calculated through a comparison between the actual charging voltage curve and the corresponding reference charging voltage curve of the battery cell, and the actual SOC of the battery cell during charging is calculated using the actual capacity and the initial SOC. Since a pre-calibrated standard reference charging voltage curve is used, the actual capacity of the battery cell can be accurately obtained through the comparison based on the voltage curve, which prevents the battery system from affecting an estimation result and is effectively applicable to a plurality of battery systems. In addition, an estimation method according to the embodiments of the present disclosure can be deployed on the server, in such a manner that a calculation efficiency is improved using computing resources of the server.

Optionally, the calculating the actual capacity and the initial SOC of the battery cell based on the actual charging voltage curve and the reference charging voltage curve of each of the one or more SOC intervals includes: calculating a root-mean-square error of the battery cell based on the actual charging voltage curve and the reference charging voltage curve of each of the one or more SOC intervals, and determining an objective function based on the root-mean-square error; and finding an optimal solution to the objective function using a least squares method to obtain the actual capacity and the initial SOC of the battery cell.

According to embodiments of the present disclosure, with the above technical means, the root-mean-square error can be calculated using the actual charging voltage curve and the reference charging voltage curve. The objective function is determined using the root-mean-square error. The actual capacity and the initial SOC of the battery cell is calculated using the least squares method to facilitate a subsequent calculation of the actual SOC of the battery cell during charging.

Optionally, the calculating the root-mean-square error of the battery cell based on the actual charging voltage curve and the reference charging voltage curve of each of the one or more SOC intervals includes: dividing a total charging duration of a reference battery cell into different charging stages; adding an interval identifier to a SOC interval corresponding to each of the different charging stages, and establishing a mathematical expression for the SOC interval, the SOC, and a capacity based on the interval identifier; and extracting the actual charging voltage curve and the corresponding reference charging voltage curve using the mathematical expression, and calculating the root-mean-square error of the battery cell based on respective mathematical expressions of the actual charging voltage curve and the reference charging voltage curve of each of the one or more SOC intervals.

According to embodiments of the present disclosure, with the above technical means, the total charging duration of the reference battery cell can be divided into the different charging stages. The interval identifiers are set for the SOC intervals in the different charging stages. The mathematical expressions for the different SOC intervals are established. Further, the actual charging voltage curve and the corresponding reference charging voltage curve are extracted using the mathematical expression. The root-mean-square error is calculated based on the respective mathematical expression of the actual charging voltage curve and the reference charging voltage curve of each SOC interval.

Optionally, the method further includes, prior to the querying the pre-established voltage feature database: constructing a charging test matrix for temperatures and charging currents; obtaining charging voltage curves at different charging temperatures and/or different charging rates based on the charging test matrix, and performing an interpolation processing on the charging voltage curves at the different charging temperatures and/or the different charging rates to obtain a plurality of reference charging voltage curves; and constructing, based on each of the one or more SOC intervals and the corresponding reference charging voltage curve, a voltage feature database.

According to embodiments of the present disclosure, with the above technical means, the charging test matrix can be constructed from two dimensions of temperature and charging current. The interpolation processing is performed on the charging voltage curves at the different charging temperatures and the different charging rates that are obtained using a charging matrix to obtain the plurality of reference charging voltage curves. The voltage feature database is constructed using the plurality of reference charging voltage curves and the SOC intervals to facilitate subsequent lookup of the corresponding reference charging voltage curves based on the SOC intervals.

Optionally, the performing the interpolation processing on the charging voltage curves at the different charging temperatures and/or the different charging rates to obtain the plurality of reference charging voltage curves includes: calculating a maximum charging capacity corresponding to all the charging voltage curves at the different charging rates; determining a stepsize of a capacity interval corresponding to each of the charging voltage curves based on the maximum charging capacity, and dividing the capacity interval into a plurality of grids based on the stepsize; and calculating a first constant based on a voltage value of each of the plurality of grids, obtaining charging voltage values under any charging currents based on the first constant, and generating the plurality of reference charging voltage curves based on the charging voltage values under the any charging currents.

According to embodiments of the present disclosure, with the above technical means, the interpolation processing can be performed on the charging voltage curves at the different charging rates. The reference charging voltage curves corresponding to the charging voltage values under the any charging currents are calculated through an equation.

Optionally, the performing the interpolation processing on the charging voltage curves at the different charging temperatures and/or the different charging rates to obtain the plurality of reference charging voltage curves includes: calculating a maximum charging capacity corresponding to all the charging voltage curves at the different charging temperatures; determining a stepsize of a capacity interval corresponding to each of the charging voltage curves based on the maximum charging capacity, and dividing the capacity interval into a plurality of grids based on the stepsize; and calculating a second constant based on a voltage value of each of the plurality of grids, obtaining voltage curves under any temperature conditions based on the second constant, and obtaining the plurality of reference charging voltage curves based on the voltage curves under the any temperature conditions.

According to embodiments of the present disclosure, with the above technical means, the interpolation processing can be performed on the charging voltage curves at the different temperatures. The reference charging voltage curves corresponding to the voltage curves under the any temperature conditions are calculated through an equation.

Optionally, the obtaining the charging voltage curves at the different charging temperatures and/or the different charging rates based on the charging test matrix includes: at a predetermined temperature, performing constant current discharge with a first predetermined current until reaching a predetermined cut-off voltage, performing, by switching to a second predetermined current, constant current discharge with the second predetermined current until reaching the predetermined cut-off voltage, letting stand for a first predetermined duration, performing constant current charge with a third predetermined current until reaching the predetermined cut-off voltage, and recording a charging voltage curve at a current charging temperature and/or a current charging rate; and letting stand for a second predetermined duration, performing constant current discharge with a fourth predetermined current until reaching the predetermined cut-off voltage, performing, by switching to a fifth predetermined current, constant current discharge with the fifth predetermined current until reaching the predetermined cut-off voltage, letting stand for a third predetermined duration, and re-performing a charging test at another charging rate and/or another charging temperature.

According to embodiments of the present disclosure, with the above technical means, the charging voltage curves at the different charging temperatures and/or the different charging rates can be obtained based on the charging test matrix to facilitate subsequent obtaining of the reference charging voltage curve based on the charging voltage curve.

In a second aspect, a method for estimating a SOC of a battery cell is provided according to an embodiment of the present disclosure. The method is applied in a server and includes: constructing a charging test matrix for temperatures and charging currents; obtaining charging voltage curves at different charging temperatures and/or different charging rates based on the charging test matrix, and performing an interpolation processing on the charging voltage curves at the different charging temperatures and/or the different charging rates to obtain a reference charging voltage curve of each SOC interval; and constructing a voltage feature database based on the reference charging voltage curve of each SOC interval, querying the reference charging voltage curve of each SOC interval using the voltage feature database, calculating an actual capacity and an initial SOC of the battery cell based on the actual charging voltage curve and the reference charging voltage curve of each SOC interval, and calculating an actual SOC of the battery cell during charging using the actual capacity and the initial SOC.

In a third aspect, an apparatus for estimating a SOC of a battery cell is provided according to an embodiment of the present disclosure. The apparatus is applied in a server and includes: an obtaining module configured to obtain actual charging data of the battery cell within one or more SOC intervals; an output module configured to: generate an actual charging voltage curve of each of the one or more SOC intervals based on actual charging data within each of the one or more SOC intervals, and query a pre-established voltage feature database using each of the one or more SOC intervals as an index to output a reference charging voltage curve of each of the one or more SOC intervals; and a first calculation module configured to: calculate an actual capacity and an initial SOC of the battery cell based on the actual charging voltage curve and the reference charging voltage curve of each of the one or more SOC intervals, and calculate an actual SOC of the battery cell during charging using the actual capacity and the initial SOC.

Optionally, the first calculation module is further configured to: calculate a root-mean-square error of the battery cell based on the actual charging voltage curve and the reference charging voltage curve of each of the one or more SOC intervals, and determine an objective function based on the root-mean-square error; and find an optimal solution to the objective function using a least squares method to obtain the actual capacity and the initial SOC of the battery cell.

Optionally, the first calculation module is further configured to: divide a total charging duration of a reference battery cell into different charging stages; add an interval identifier to a SOC interval corresponding to each of the different charging stages, and establish a mathematical expression for the SOC interval, the SOC, and a capacity based on the interval identifier; and extract the actual charging voltage curve and the corresponding reference charging voltage curve using the mathematical expression, and calculate the root-mean-square error of the battery cell based on respective mathematical expressions of the actual charging voltage curve and the reference charging voltage curve of each of the one or more SOC intervals.

Optionally, the apparatus further includes a processing module. The processing module is configured to, prior to the querying the pre-established voltage feature database: construct a charging test matrix for temperatures and charging currents; obtain charging voltage curves at different charging temperatures and/or different charging rates based on the charging test matrix, and perform an interpolation processing on the charging voltage curves at the different charging temperatures and/or the different charging rates to obtain a plurality of reference charging voltage curves; and construct, based on each of the one or more SOC intervals and the corresponding reference charging voltage curve, a voltage feature database.

Optionally, the processing module is further configured to: calculate a maximum charging capacity corresponding to all the charging voltage curves at the different charging rates; determine a stepsize of a capacity interval corresponding to each of the charging voltage curves based on the maximum charging capacity, and divide the capacity interval into a plurality of grids based on the stepsize; and calculate a first constant based on a voltage value of each of the plurality of grids, obtain charging voltage values under any charging currents based on the first constant, and generate the plurality of reference charging voltage curves based on the charging voltage values under the any charging currents.

Optionally, the processing module is further configured to: calculate a maximum charging capacity corresponding to all the charging voltage curves at the different charging temperatures; determine a stepsize of a capacity interval corresponding to each of the charging voltage curves based on the maximum charging capacity, and divide the capacity interval into a plurality of grids based on the stepsize; and calculate a second constant based on a voltage value of each of the plurality of grids, obtain voltage curves under any temperature conditions based on the second constant, and obtain the plurality of reference charging voltage curves based on the voltage curves under the any temperature conditions.

Optionally, the processing module is further configured to: at a predetermined temperature, perform constant current discharge with a first predetermined current until reaching a predetermined cut-off voltage, perform, by switching to a second predetermined current, constant current discharge with the second predetermined current until reaching the predetermined cut-off voltage, let stand for a first predetermined duration, perform constant current charge with a third predetermined current until reaching the predetermined cut-off voltage, and record a charging voltage curve at a current charging temperature and/or a current charging rate; and let stand for a second predetermined duration, perform constant current discharge with a fourth predetermined current until reaching the predetermined cut-off voltage, perform, by switching to a fifth predetermined current, constant current discharge with the fifth predetermined current, until reaching the predetermined cut-off voltage, let stand for a third predetermined duration, and re-perform a charging test at another charging rate and/or another charging temperature.

In a fourth aspect, an apparatus for estimating a SOC of a battery cell is provided according to an embodiment of the present disclosure. The apparatus is applied in a server and includes: a construction module configured to construct a charging test matrix for temperatures and charging currents; an interpolation module configured to: obtain charging voltage curves at different charging temperatures and/or different charging rates based on the charging test matrix, and perform an interpolation processing on the charging voltage curves at the different charging temperatures and/or the different charging rates to obtain a reference charging voltage curve of each SOC interval; and a second calculation module configured to: construct a voltage feature database based on the reference charging voltage curve of each SOC interval, query the reference charging voltage curve of each SOC interval using the voltage feature database, calculate an actual capacity and an initial SOC of the battery cell based on the actual charging voltage curve and the reference charging voltage curve of each SOC interval, and calculate an actual SOC of the battery cell during charging using the actual capacity and the initial SOC.

In a fifth aspect, a server is provided according to an embodiment of the present disclosure. The server includes: a memory; a processor; and a computer program stored in the memory and executable on the processor. The processor, when executing the computer program, implements the method for estimating the SOC of the battery cell according to the above embodiments.

In a sixth aspect, a computer-readable storage medium is provided according to an embodiment of the present disclosure. The computer-readable storage medium stores a computer program. The computer program, when executed by a processor, implements the method for estimating the SOC of the battery cell according to the above embodiments.

Therefore, the present disclosure can at least provide the following advantageous effects.

(1) According to the embodiments of the present disclosure, the actual capacity and an initial SOC of the battery cell can be accurately calculated through the comparison between the actual charging voltage curve and the corresponding reference charging voltage curve of the battery cell, and the actual SOC of the battery cell during charging is calculated using the actual capacity and the initial SOC. Since the pre-calibrated standard reference charging voltage curve is used, the actual capacity of the battery cell can be accurately obtained through the comparison based on the voltage curve, which prevents the battery system from affecting the estimation result and is effectively applicable to the plurality of battery systems. In addition, the estimation method according to the embodiments of the present disclosure can be deployed on the server, in such a manner that the calculation efficiency is improved using computing resources of the server.

(2) According to the embodiments of the present disclosure, the root-mean-square error can be calculated using the actual charging voltage curve and the reference charging voltage curve. The objective function is determined using the root-mean-square error. The actual capacity and the initial SOC of the battery cell is calculated using the least squares method to facilitate the subsequent calculation of the actual SOC of the battery cell during charging.

(3) According to the embodiments of the present disclosure, the total charging duration of the reference battery cell can be divided into the different charging stages. The interval identifiers are set for the SOC intervals in the different charging stages. The mathematical expressions for the different SOC intervals are established. Further, the actual charging voltage curve and the corresponding reference charging voltage curve are extracted using the mathematical expression. The root-mean-square error is calculated based on the respective mathematical expression of the actual charging voltage curve and the reference charging voltage curve of each SOC interval.

(4) According to the embodiments of the present disclosure, the charging test matrix can be constructed from the two dimensions of temperature and charging current. The interpolation processing is performed on the charging voltage curves at the different charging temperatures and the different charging rates that are obtained using the charging matrix to obtain the plurality of reference charging voltage curves. The voltage feature database is constructed using the plurality of reference charging voltage curves and the SOC intervals to facilitate the subsequent lookup of the corresponding reference charging voltage curves based on the SOC intervals.

(5) According to the embodiments of the present disclosure, the interpolation processing can be performed on the charging voltage curves at the different charging rates. The reference charging voltage curves corresponding to the charging voltage values under the any charging currents are calculated through the equation.

(6) According to the embodiments of the present disclosure, the interpolation processing can be performed on the charging voltage curves at the different temperatures. The reference charging voltage curves corresponding to the voltage curves under the any temperature conditions are calculated through the equation.

(7) According to the embodiments of the present disclosure, the charging voltage curves at the different charging temperatures and/or the different charging rates can be obtained based on the charging test matrix to facilitate the subsequent obtaining of the reference charging voltage curve based on the charging voltage curve.

Therefore, technical problems in the related art such as the failure to meet expectations in terms of the calculation performance and the low calculation accuracy due to the fact that the method for calculating the SOC cannot be applied to the wide range of battery systems are solved.

Additional aspects and advantages of the present disclosure will be provided at least in part in the following description, or will become apparent at least in part from the following description, or can be learned from practicing of the present disclosure.

## BRIEF DESCRIPTION OF DRAWINGS

The above and/or additional aspects and advantages of the present disclosure will become more apparent and more understandable from the following description of embodiments taken in conjunction with the accompanying drawings.

FIG. 1 is a flowchart of a method for estimating a SOC of a battery cell according to an embodiment of the present disclosure.

FIG. 2 is a schematic diagram illustrating a charging interval division and interval identifiers according to an embodiment of the present disclosure.

FIG. 3 is a flowchart of a method for estimating a SOC of a battery cell according to an embodiment of the present disclosure.

FIG. 4 is a schematic diagram illustrating a charging interval division and interval identifiers of any battery cell in a LFP battery pack according to an embodiment of the present disclosure.

FIG. 5 illustrates a charging voltage curve of each battery cell in a LFP battery pack according to an embodiment of the present disclosure.

FIG. 6 illustrates a SOC value and a charging voltage curve of each battery cell in a LFP battery pack according to an embodiment of the present disclosure.

FIG. 7 is a flowchart of a method for estimating a SOC of a battery cell according to another embodiment of the present disclosure.

FIG. 8 is an example diagram of an apparatus for estimating a SOC of a battery cell according to an embodiment of the present disclosure.

FIG. 9 is an example diagram of an apparatus for estimating a SOC of a battery cell according to another embodiment of the present disclosure.

FIG. 10 is a block diagram showing a structure of a server according to an embodiment of the present disclosure.

## DESCRIPTION OF THE EMBODIMENTS

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limit, the present disclosure.

A method and apparatus for estimating a SOC of a battery cell, a server, and a storage medium according to the embodiments of the present disclosure are described below with reference to the accompanying drawings. To solve problems mentioned in BACKGROUND that a conventional method for calculating a SOC result in a large error, has a low accuracy, and falls short of expectations in terms of calculation performance, the present disclosure provides a method for estimating a SOC of a battery cell. In the method, the actual capacity and the initial SOC of the battery cell can be accurately calculated through a comparison between the actual charging voltage curve and the corresponding reference charging voltage curve of the battery cell, and the actual SOC of the battery cell during charging is calculated using the actual capacity and the initial SOC. Since a pre-calibrated standard reference charging voltage curve is used, the actual capacity of the battery cell can be accurately obtained through the comparison based on the voltage curve, which prevents the battery system from affecting an estimation result and is effectively applicable to a plurality of battery systems. In addition, an estimation method according to the embodiments of the present disclosure can be deployed on the server, in such a manner that a calculation efficiency is improved using computing resources of the server. Therefore, technical problems in the related art such as a failure to meet expectations in terms of calculation performance and a low calculation accuracy due to a fact that a method for calculating the SOC cannot be applied to a wide range of battery systems are solved.

Before describing the method for estimating the SOC of the battery cell according to the embodiments of the present disclosure, it should be noted that there are various methods for calculating the SOC in the related art, but all of them have corresponding defects. Coulomb counting method is constrained by an accuracy of a current sensor, with errors accumulating over time. An OCV lookup table method is used in demanding scenarios, especially in a low-temperature environment, necessitating a relatively long standing duration before use. Moreover, for a LFP battery, a voltage platform makes the OCV lookup table method impractical. The Kalman filter method still faces an issue of algorithm divergence, particularly in a LFP voltage platform region, which prevents normal use of the Kalman filter method. Therefore, to calculate the SOC value of the LFP battery more accurately, more complex electrochemical models and algorithms need to be developed. However, due to limitations in a hardware configuration of a BMS on a vehicle, these complex models cannot perform a computation in real time on the vehicle, making it impossible to deploy such models and algorithms on the vehicle. In contrast, cloud servers possess robust data storage and computational capabilities, allowing algorithms deployed on the cloud to operate without restrictions on complexity. Therefore, the method for estimating the SOC of the battery cell according to the embodiments of the present disclosure is deployed on the server.

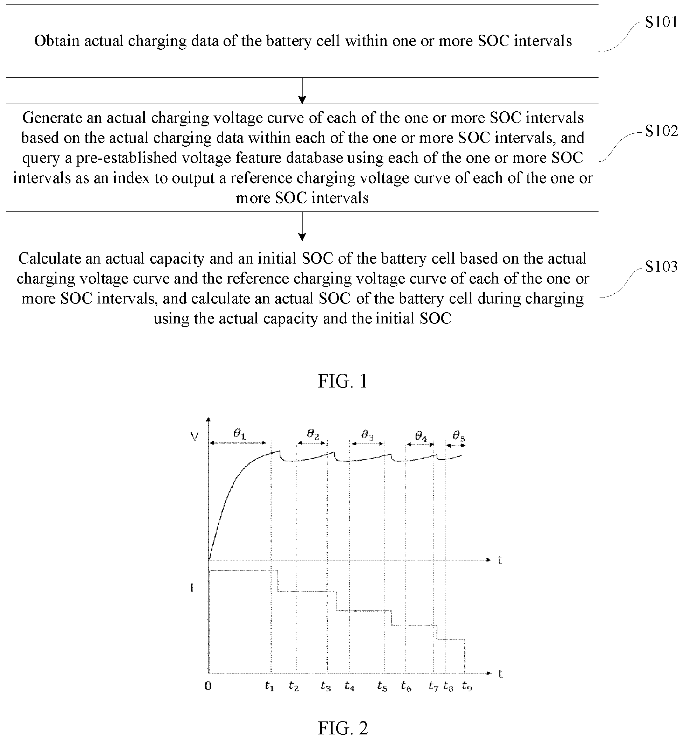

Specifically, FIG. 1 is a flowchart illustrating a method for estimating a SOC of a battery cell according to an embodiment of the present disclosure.

As illustrated in FIG. 1, the method for estimating the SOC of the battery cell is applied in a server and the method includes following steps.

In step S101, obtain actual charging data of the battery cell within one or more SOC intervals.

The battery cell may be any battery cell, such as a battery cell in a LFP battery pack, a battery cell in an NiMH battery, and a battery cell in a Li-ion battery.

In step S102, generate an actual charging voltage curve of each of the one or more SOC intervals based on the actual charging data within each of the one or more SOC intervals, and query a pre-established voltage feature database using each of the one or more SOC intervals as an index to output a reference charging voltage curve of each of the one or more SOC intervals.

The voltage feature database stores a relationship between SOC intervals and reference charging voltage curves (i.e., standard charging voltage curves). A specific method for establishing the relationship is described in the following embodiments, and thus details thereof will be omitted here.

It should be understood that, in the embodiments of the present disclosure, the actual charging voltage curve of each SOC interval can be generated based on the actual charging data of the battery cell within each SOC interval. The reference charging voltage curve corresponding to each SOC interval is queried in the pre-established voltage feature database. A required value is subsequently calculated based on the actual charging voltage curve and the reference charging voltage curve.

In an embodiment of the present disclosure, the method further includes, prior to the querying the pre-established voltage feature database: constructing a charging test matrix for temperatures and charging currents; obtaining charging voltage curves at different charging temperatures and/or different charging rates based on the charging test matrix, and performing an interpolation processing on the charging voltage curves at the different charging temperatures and/or the different charging rates to obtain a plurality of reference charging voltage curves; and constructing, based on each of the one or more SOC intervals and the reference charging voltage curve, a voltage feature database.

It should be understood that, in the embodiments of the present disclosure, the charging test matrix is constructed from two dimensions of temperature and charging current, as shown in Table 1. The charging voltage curves at the different charging temperatures and the different charging rates are obtained based on the charging test matrix. The interpolation processing is performed on the charging voltage curves at the different charging temperatures and the different charging rates to obtain the reference charging voltage curves. The voltage feature database is constructed based on each SOC interval and the reference charging voltage curve corresponding to each SOC interval. Table 1 is a charging test matrix table.

Table 1

| Temperature | $T_1$ | $T_2$ | $T_3$ | $T_4$ | $T_5$ | $T_6$ | $T_7$ |
|---|---|---|---|---|---|---|---|
| Charging current | $I_{11}$ | $I_{12}$ | $I_{13}$ | $I_{14}$ | $I_{15}$ | $I_{16}$ | $I_{17}$ |
| | $I_{21}$ | $I_{22}$ | $I_{23}$ | $I_{24}$ | $I_{25}$ | $I_{26}$ | $I_{27}$ |
| | $I_{31}$ | $I_{32}$ | $I_{33}$ | $I_{34}$ | $I_{35}$ | $I_{36}$ | $I_{37}$ |
| | $I_{41}$ | $I_{42}$ | $I_{43}$ | $I_{44}$ | $I_{45}$ | $I_{46}$ | $I_{47}$ |
| | $I_{51}$ | $I_{52}$ | $I_{53}$ | $I_{54}$ | $I_{55}$ | $I_{56}$ | $I_{57}$ |

Further, in an embodiment of the present disclosure, the obtaining the charging voltage curves at the different charging temperatures and/or the different charging rates based on the charging test matrix includes: at a predetermined temperature, performing constant current discharge with a first predetermined current until reaching a predetermined cut-off voltage, performing, by switching to a second predetermined current, constant current discharge with the second predetermined current until reaching the predetermined cut-off voltage, letting stand for a first predetermined duration, performing constant current charge with a third predetermined current until reaching the predetermined cut-off voltage, and recording a charging voltage curve at a current charging temperature and/or a current charging rate; and letting stand for a second predetermined duration, performing constant current discharge with a fourth predetermined current until reaching the predetermined cut-off voltage, performing, by switching to a fifth predetermined current, constant current discharge with the fifth predetermined current until reaching the predetermined cut-off voltage, letting stand for a third predetermined duration, and re-performing a charging test at another charging rate and/or another charging temperature.

The predetermined temperature can be set as desired, which is applicable to a charging and discharging process under a constant temperature condition. The first predetermined current, the second predetermined current, the third predetermined current, the fourth predetermined current, and the fifth predetermined current can be set as desired. Also, the first predetermined duration, the second predetermined duration, and the third predetermined duration can be set as desired. The present disclosure is not limited in this regard.

Taking charging temperature $T_1$ and charging rate $I_{15}$ as an example, a method for obtaining the charging voltage curve is as follows.

1. Constant current discharge is performed with 0.3C until reaching the predetermined cut-off voltage, the constant current discharge is continuously performed through switching to 0.05C until reaching the predetermined cut-off voltage, let stand for 0.5 hours, constant current charge is performed at $I_{15}$ until reaching a cut-off voltage, and a voltage curve is recorded.

2. Let stand for 0.5 hours, the constant current discharge is performed with 0.3C until reaching the cut-off voltage, the constant current discharge is continuously performed through switching to 0.05C until reaching the cut-off voltage, and let stand for 0.5 hours. After charging at $I_{15}$ is completed, charging tests at other rates are restarted.

In an embodiment of the present disclosure, the performing the interpolation processing on the charging voltage curves at the different charging temperatures and/or the different charging rates to obtain the plurality of reference charging voltage curves includes: calculating a maximum charging capacity corresponding to all the charging voltage curves at the different charging rates; determining a stepsize of a capacity interval corresponding to each of the charging voltage curves based on the maximum charging capacity, and dividing the capacity interval into a plurality of grids based on the stepsize; and calculating a first constant based on a voltage value of each of the plurality of grids, obtaining charging voltage values under any charging currents based on the first constant, and generating the plurality of reference charging voltage curves based on the charging voltage values under the any charging currents.

Specifically, in an embodiment of the present disclosure, subsequent to obtaining the voltage curves at the different temperatures and the different charging rates, the interpolation processing needs to be performed. By taking charging voltage curves at temperature $T_1$ and at different rates as an example, an interpolation processing method is as follows.

The maximum charging capacity $Q_{max}$ corresponding to all the charging voltage curves at different rates is calculated. A capacity interval corresponding to all the charging curves is divided into 100 grids with a stepsize of $Q_{max}/100$. In each grid, the following equation is satisfied:

$$AB = V, (1)$$

In equation (1), A=(kb), B=(I 1)$^T$, and V represents a voltage value in the grid. The above linear equation (1) is solved to obtain values of k and b. The charging voltage value at any charging current can be obtained based on the values of k and b.

In an embodiment of the present disclosure, the performing the interpolation processing on the charging voltage curves at the different charging temperatures and/or the different charging rates to obtain the plurality of reference charging voltage curves includes: calculating a maximum charging capacity corresponding to all the charging voltage curves at the different charging temperatures; determining a stepsize of a capacity interval corresponding to each of the charging voltage curves based on the maximum charging capacity, and dividing the capacity interval into a plurality of grids based on the stepsize; and calculating a second constant based on a voltage value of each of the plurality of grids, obtaining voltage curves under any temperature conditions based on the second constant, and obtaining the plurality of reference charging voltage curves based on the voltage curves under the any temperature conditions.

Specifically, taking the charging voltage curve at charging rate $I_{11}$ as an example, the plurality of reference charging voltage curves at the any temperature condition are obtained through the following method.

The maximum charging capacity $Q_{max}$ corresponding to all the charging voltage curves at different temperatures is calculated. A capacity interval corresponding to all the charging curves is divided into 100 grids with a stepsize of $Q_{max}/100$. In each grid, the following equation is satisfied:

$$V = ae^{c/T}, (2)$$

The equation (2) is solved to obtain values of a and c. The voltage curve under the any temperature condition can be obtained based on the values of a and c.

In step S103, calculate an actual capacity and an initial SOC of the battery cell based on the actual charging voltage curve and the reference charging voltage curve of each of the one or more SOC intervals, and calculate an actual SOC of the battery cell during charging using the actual capacity and the initial SOC.

It should be understood that, in the embodiments of the present disclosure, the reference charging voltage curve corresponding to each SOC interval is queried in the pre-established voltage feature database. The actual capacity and the initial SOC of the battery cell are calculated using the actual charging voltage curve and the reference charging voltage curve. The actual SOC of the battery cell during charging is calculated based on the actual capacity and the initial SOC of the battery cell. A specific calculation method is described as follows.

In an embodiment of the present disclosure, the calculating the actual capacity and the initial SOC of the battery cell based on the actual charging voltage curve and the reference charging voltage curve of each of the one or more SOC intervals includes: calculating a root-mean-square error of the battery cell based on the actual charging voltage curve and the reference charging voltage curve of each of the one or more SOC intervals, and determining an objective function based on the root-mean-square error; and finding an optimal solution to the objective function using a least squares method to obtain the actual capacity and the initial SOC of the battery cell.

The calculating the root-mean-square error based on the actual charging voltage curve and the reference charging voltage curve of each of the one or more SOC intervals includes: dividing a total charging duration of a reference battery cell into different charging stages; adding an interval identifier to a SOC interval corresponding to each of the different charging stages, and establishing a mathematical expression for the SOC interval, the SOC, and a capacity based on the interval identifier; and extracting the actual charging voltage curve and the corresponding reference charging voltage curve using the mathematical expression, and calculating the root-mean-square error of the battery cell based on respective mathematical expressions of the actual charging voltage curve and the reference charging voltage curve of each of the one or more SOC intervals.

It should be understood that, in the embodiments of the present disclosure, the total charging duration may be divided into the different charging stages based on a numerical change of an actual charging current of the reference battery cell. The SOC interval corresponding to each charging stage of the battery cell is identified. The mathematical expression for the SOC interval, the SOC, and the capacity is established based on the interval identifier. The actual charging voltage curve and the corresponding reference charging voltage curve are extracted based on the mathematical expression. The root-mean-square error of the battery cell is calculated based on respective mathematical expressions of the actual charging voltage curve and the corresponding reference charging voltage curve of each of the one or more SOC intervals. The objective function is determined based on the root-mean-square error. The optimal solution to the objective function is found using the least squares method to obtain the actual capacity and the initial SOC of the battery cell.

Specifically, in the embodiments of the present disclosure, an entire charging process is divided into several intervals. Time point $t_1$ falls within a first charging stage, with a charging SOC interval corresponding to time point $t_1$

denoted as $\theta_1$. Time point $t_2$ falls within a second charging stage. A charging voltage has tended towards stability at time point $t_2$. Time point $t_3$ is a time point when the second charging stage is about to end, with a charging SOC interval corresponding to time point $t_2$ to time point $t_3$ denoted as $\theta_2$. Time point $t_4$ falls within a third charging stage. A charging voltage curve has tended towards stability at time point $t_4$. Time point $t_5$ is a time point when the third charging stage is about to end, with a charging SOC interval corresponding to time point $t_4$ to time point $t_5$ denoted as $\theta_3$. Time intervals and SOC intervals in other charging stages are divided in ways similar to those in the above description, and are denoted as $t_6, t_7, \theta_4$; $t_8, t_9, \theta_5, ...,$ respectively, as illustrated in FIG. 2.

Interval expressions for different SOC charging intervals $\theta_1, \theta_2, \theta_3, \theta_4, ...$ are established. A SOC of a battery cell numbered i at a start time point of charging is denoted as $x_0^i$. A capacity of the battery cell numbered i is denoted as $Q_0^i$. The expressions for the different SOC intervals are as follows:

$$\theta_1^i \in [x_0^i, x_0^i + \frac{\int_0^{t_1} I dt}{Q_0^i}], \quad (3)$$

$$\theta_2^i \in [x_0^i + \frac{\int_0^{t_2} I dt}{Q_0^i}, x_0^i + \frac{\int_0^{t_3} I dt}{Q_0^i}], \quad (4)$$

$$\theta_3^i \in [x_0^i + \frac{\int_0^{t_4} I dt}{Q_0^i}, x_0^i + \frac{\int_0^{t_5} I dt}{Q_0^i}], \quad (5)$$

$$\theta_4^i \in [x_0^i + \frac{\int_0^{t_6} I dt}{Q_0^i}, x_0^i + \frac{\int_0^{t_7} I dt}{Q_0^i}], \quad (6)$$

$$\ldots$$

Actual charging voltage curves corresponding to different SOC intervals are extracted from an overall charging voltage curve based on the interval identifiers and interval expressions. As illustrated in FIG. 2, actual charging voltage curves corresponding to different charging stages are extracted and denoted as $V_1^i(\theta_1^i)$, $V_2^i(\theta_2^i)$, $V_3^i(\theta_3^i)$, $V_4^i(\theta_4^i)$, $\cdots$, respectively.

Further, subsequent to the obtaining the actual charging voltage curves, the reference charging voltage curve (V(I,T,x)) in the voltage feature database is queried based on temperatures and current values in different charging stages during actual charging. Root-mean-square errors between the actual charging voltage curves ($V_1^i(\theta_1^i)$, $V_2^i(\theta_2^i)$, $V_3^i(\theta_3^i)$, $V_4^i(\theta_4^i)$, $\cdots$) and the reference charging voltage curves of individual battery cells are calculated. The actual capacity $Q_0^i$ and the initial $SOC x_0^i$ of each battery cell are calculated based on the least squares method. A calculation equation is as follows:

$$RLS = \left( K_1 \sum \left( V(I_1, T_1, x) - V_1^i(\theta_1^i) \right)^2 + K_2 \sum \left( V(I_2, T_2, x) - V_2^i(\theta_2^i) \right)^2 + \right.$$

$$\left. K_3 \sum \left( V(I_3, T_3, x) - V_3^i(\theta_3^i) \right)^2 + K_4 \sum \left( V(I_4, T_4, x) - V_4^i(\theta_4^i) \right)^2 + \cdots \right)^{1/2}, \quad (7)$$

In equation (7), $K_1$, $K_2$, $K_3$, $K_4$, ... represent weights during optimization for individual charging stages, respectively. $x_0^i$ and $Q_0^i$ can be obtained using equation (7). By substituting $x_0^i$ and $Q_0^i$ into the following equation, a SOC upper limit of the battery cell numbered i during the actual charging can be calculated:

$$x^i_{max} = x^i_0 + \frac{\int_0^{t_9} I dt}{Q^i_0}, (8)$$

Therefore, the SOC interval of the battery cell numbered i during the actual charging can be expressed as $x \in [x_0, x_{max}]$.

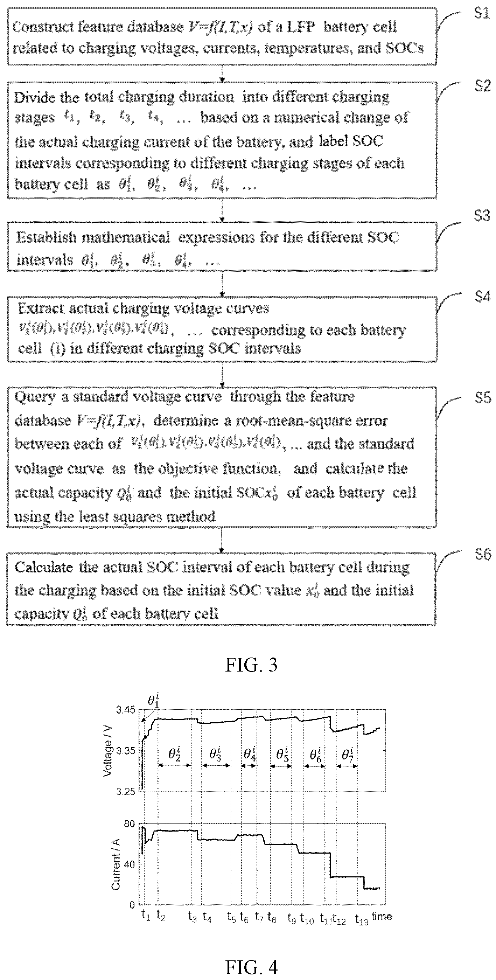

The method for estimating the SOC of the battery cell according to the embodiments of the present disclosure is described below using a specific embodiment. As illustrated in FIG. 3, the method includes the following specific steps.

In step S1, construct feature database $V=f(I, T, x)$ of a LFP battery cell related to charging voltages, currents, temperatures, and SOCs. That is, a feature database of standard charging voltage curves (reference charging voltage curves) of the LFP battery cell is constructed.

1. A LFP charging test matrix is constructed.

The charging test matrix is constructed from the two dimensions of temperature and charging current based on a performance reference table of the LFP battery cell, as illustrated in Table 2, which is a charging test matrix table of the LFP battery cell.

Table 2

| Temperature | -20°C | -10°C | 0°C | 10°C | 25°C | 35°C | 45°C |
|---|---|---|---|---|---|---|---|
| Charging | 0.05C | 0.05C | 0.05C | 0.05C | 0.05C | 0.05C | 0.05C |
| current | 0.1C | 0.1C | 0.1C | 0.1C | 0.1C | 0.1C | 0.1C |
| | 0.2C | 0.2C | 0.2C | 0.3C | 0.5C | 0.5C | 0.3C |
| | 0.3C | 0.3C | 0.3C | 0.5C | 1C | 1C | 0.5C |
| | 0.4C | 0.4C | 0.4C | 1C | 2C | 2C | 1C |

2. The standard charging voltage curve is obtained.

By taking a charging temperature of 25°C and a charging rate of 1C as an example, a method for obtaining the reference charging voltage curve is as follows.

A. Constant current discharge is performed with 0.3C until reaching the predetermined cut-off voltage, the constant current discharge is continuously performed through switching to 0.05C until reaching the predetermined cut-off voltage, let stand for 0.5 hours, constant current charge is performed with 1C until reaching a cut-off voltage, and a voltage curve is recorded.
B. Let stand for 0.5 hours, the constant current discharge is performed with 0.3C until reaching the cut-off voltage, the constant current discharge is continuously performed through switching to 0.05C until reaching the cut-off voltage, and let stand for 0.5 hours.
C. After charging with 1C is completed, charging tests at other rates are restarted.

3. The feature database is constructed.

Subsequent to the obtaining the voltage curves at the different temperatures and the different charging rates, the interpolation processing needs to be performed. By taking charging voltage curves at 25°C and at different rates as an example, an interpolation processing method is as follows.

The maximum charging capacity $Q_{max}=100$ Ah corresponding to all the charging voltage curves at different rates is calculated. The capacity interval corresponding to all the charging curves is divided into 100 grids with a stepsize of 1 Ah. In each grid, equation (1) is satisfied. Equation (1) is solved to obtain values of k and b. The charging voltage value at any charging current can be obtained based on the values of k and b.

By taking the charging voltage curve at the charging rate of 0.1C as an example, a feature database of the dimension of temperature can be obtained through the following method.

The maximum charging capacity $Q_{max}=98$ Ah corresponding to all the charging voltage curves at different temperatures is calculated. The capacity interval corresponding to all the charging curves is divided into 100 grids with a stepsize of 0.98 Ah. In each grid, equation (2) is satisfied. Equation (2) is solved to obtain values of a and c. The voltage curve at any temperature condition can be obtained based on the values of a and c.

In step S2, divide the total charging duration into different charging stages $t_1$, $t_2$, $t_3$, $t_4$, ... based on a numerical change of the actual charging current of the battery, and label SOC intervals corresponding to different charging stages of each battery cell as $\theta_1^i$, $\theta_2^i$, $\theta_3^i$, $\theta_4^i$, ...

FIG. 4 illustrates an actual charging curve of any battery cell numbered i in a LFP battery pack of a certain type, in which the entire charging process is divided into 7 SOC intervals. A charging duration corresponding to $\theta_1^i$ is [0 $t_1$]. A charging duration corresponding to $\theta_2^i$ is [$t_2 t_3$]. A charging duration corresponding to $\theta_3^i$ is [$t_4 t_5$]. A charging duration corresponding to $\theta_4^i$ is [$t_6 t_7$], A charging duration corresponding to $\theta_5^i$ is [$t_8 t_9$]. A charging duration corresponding to $\theta_6^i$ is [$t_{10} t_{11}$]. A charging duration corresponding to $\theta_7^i$ is [$t_{12} t_{13}$]. Values of $t_1$~$t_{13}$ are illustrated in Table 3, in unit of hour. Table 3 shows divisions of durations corresponding to different charging processes.

Table 3

| $t_1$ | $t_2$ | $t_3$ | $t_4$ | $t_5$ | $t_6$ | $t_7$ | $t_8$ | $t_9$ | $t_{10}$ | $t_{11}$ | $t_{12}$ | t13 |
|---|---|---|---|---|---|---|---|---|---|---|---|---|
| 0.03 | 0.11 | 0.29 | 0.31 | 0.42 | 0.45 | 0.5 | 0.53 | 0.61 | 0.63 | 0.72 | 0.74 | 0.83 |

In step S3, establish interval expressions for the different SOC intervals $\theta_1^i$, $\theta_2^i$, $\theta_3^i$, $\theta_4^i$, ...

A standard capacity of the selected LFP battery cell is 90 Ah at a temperature. The SOC (i.e., initial SOC) of the battery cell numbered i at the start time point of charging is denoted as $x_0^i$. The capacity of the battery cell numbered i is denoted as $Q_0^i$. Expressions for the different SOC intervals are as follows:

$$\theta_1^i \in \left[ x_0^i, x_0^i + 0.026 \right],$$

$$\theta_2^i \in \left[ x_0^i + 0.1, x_0^i + 0.26 \right],$$

$$\theta_3^i \in \left[ x_0^i + 0.28, x_0^i + 0.37 \right],$$

$$\theta_4^i \in \left[ x_0^i + 0.4, x_0^i + 0.44 \right],$$

$$\theta_5^i \in \left[ x_0^i + 0.47, x_0^i + 0.54 \right],$$

$$\theta_6^i \in \left[ x_0^i + 0.56, x_0^i + 0.64 \right],$$

$$\theta_7^i \in \left[ x_0^i + 0.66, x_0^i + 0.74 \right].$$

In step S4, extract actual charging voltage curves corresponding to each battery cell (i) in different charging SOC intervals.

As illustrated in FIG. 4, the actual charging voltage curves corresponding to the different charging stages are extracted and denoted as $V_1^i(\theta_1^i), V_2^i(\theta_2^i), V_3^i(\theta_3^i), V_4^i(\theta_4^i), V_5^i(\theta_5^i), V_6^i(\theta_6^i), V_7^i(\theta_7^i)$, respectively.

In step S5, query a standard voltage curve through the feature database, a root-mean-square error between each of $V_1^i(\theta_1^i), V_2^i(\theta_2^i), V_3^i(\theta_3^i), V_4^i(\theta_4^i)$, ... and determine the standard voltage curve as the objective function, and calculate $Q_0^i$ and the initial $SOCx_0^i$ of each battery cell using the least squares method.

The reference charging voltage curve (V(I,T,x)) in the voltage feature database is queried based on the temperatures and the current values in the different charging stages during the actual charging. The root-mean-square errors between the actual charging voltage curves ( $V_1^i(\theta_1^i)$, $V_2^i(\theta_2^i)$, $V_3^i(\theta_3^i)$, $V_4^i(\theta_4^i)$, ... ) and the reference charging voltage curves of individual battery cells are calculated. The actual capacity $Q_0^i$ and the initial $SOCx_0^i$ of each battery cell are calculated based on the least squares method. A calculation equation is as follows:

$$RLS = \left( K_1 \sum \left( V(I_1, T_1, x) - V_1^i(\theta_1^i) \right)^2 + K_2 \sum \left( V(I_2, T_2, x) - V_2^i(\theta_2^i) \right)^2 + \right.$$

$$K_3 \sum \left( V(I_3, T_3, x) - V_3^i(\theta_3^i) \right)^2 + K_4 \sum \left( V(I_4, T_4, x) - V_4^i(\theta_4^i) \right)^2 + K_5 \sum \left( V(I_5, T_5, x) - \right.$$

$$\left. V_5^i(\theta_5^i) \right)^2 + K_6 \sum \left( V(I_6, T_6, x) - V_6^i(\theta_6^i) \right)^2 + K_7 \sum \left( V(I_7, T_7, x) - V_7^i(\theta_7^i) \right)^2 \right)^{1/2},$$

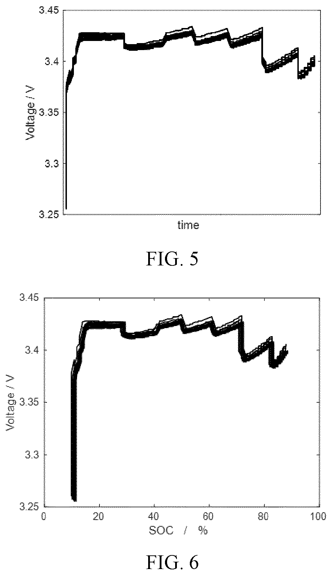

in the above equation, $K_1$, $K_2$, $K_3$, $K_4$, $K_5$, $K_6$, and $K_7$ represent weights during optimization for individual charging stages, respectively. The actual capacity $Q_0^i$ and the initial $SOCx_0^i$ of each battery cell are calculated, results of which are shown in Table 4. Table 4 shows the capacity and the initial SOC of each battery cell in the LFP battery pack. It should be noted that there are some differences in the charging curves of individual battery cells in the battery pack, as illustrated in FIG. 5.

Table 4

| Cell No. | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|
| Capacity /Ah | 89.15 | 89.6 | 89.45 | 89 | 90.03 | 88.95 | 89.3 | 89.25 | 89.23 | 88.23 | 88.75 | 90.25 | 88.91 | 89.5 | 89.62 |
| Initial SOC | 0.15 | 0.14 | 0.15 | 0.15 | 0.14 | 0.15 | 0.15 | 0.13 | 0.14 | 0.15 | 0.15 | 0.14 | 0.13 | 0.14 | 0.13 |
| Cell No. | 16 | 17 | 18 | 19 | 20 | 21 | 22 | 23 | 24 | 25 | 26 | 27 | 28 | 29 | 30 |
| Capacity /Ah | 89.3 | 89.32 | 89.62 | 89.41 | 89.25 | 89.63 | 89.74 | 89.54 | 89.52 | 89.1 | 89.36 | 89 | 89.44 | 89.25 | 89.21 |
| Initial SOC | 0.13 | 0.14 | 0.15 | 0.15 | 0.14 | 0.15 | 0.13 | 0.14 | 0.13 | 0.15 | 0.15 | 0.13 | 0.14 | 0.13 | 0.15 |
| Cell No. | 31 | 32 | 33 | 34 | 35 | 36 | 37 | 38 | 39 | 40 | 41 | 42 | 43 | 44 | 45 |
| Capacity /Ah | 89.66 | 89.85 | 89.75 | 89.94 | 89.69 | 90.2 | 90.12 | 89.05 | 88.98 | 87.6 | 88.65 | 88.78 | 89.63 | 88.76 | 88.65 |
| Initial SOC | 0.15 | 0.13 | 0.14 | 0.13 | 0.15 | 0.15 | 0.15 | 0.13 | 0.14 | 0.13 | 0.15 | 0.14 | 0.13 | 0.12 | 0.13 |
| Cell No. | 46 | 47 | 48 | 49 | 50 | 51 | 52 | 53 | 54 | 55 | 56 | 57 | 58 | 59 | 60 |
| Capacity /Ah | 89.33 | 89.65 | 89.32 | 89.62 | 89.41 | 89.25 | 90.12 | 89.05 | 88.98 | 88.75 | 90.12 | 90.25 | 89.74 | 89.54 | 89.52 |
| Initial SOC | 0.14 | 0.14 | 0.15 | 0.15 | 0.15 | 0.15 | 0.15 | 0.14 | 0.15 | 0.15 | 0.15 | 0.15 | 0.15 | 0.14 | 0.13 |
| Cell No. | 61 | 62 | 63 | 64 | 65 | 66 | 67 | 68 | 69 | 70 | 71 | 72 | 73 | 74 | 75 |
| Capacity /Ah | 89.64 | 89.25 | 89.63 | 89 | 89.44 | 89.25 | 89.21 | 89.41 | 89.25 | 90.12 | 89.05 | 88.98 | 88.5 | 87.96 | 88.96 |
| Initial SOC | 0.15 | 0.14 | 0.14 | 0.15 | 0.14 | 0.15 | 0.15 | 0.13 | 0.14 | 0.15 | 0.15 | 0.14 | 0.15 | 0.15 | 0.13 |
| Cell No. | 76 | 77 | 78 | 79 | 80 | 81 | 82 | 83 | 84 | 85 | 86 | 87 | 88 | 89 | 90 |
| Capacity /Ah | 88.65 | 88.78 | 89.63 | 89.69 | 90.2 | 90.12 | 89.05 | 89.75 | 89.94 | 89.74 | 89.54 | 89.52 | 88.75 | 90.12 | 88.91 |
| Initial SOC | 0.15 | 0.14 | 0.13 | 0.15 | 0.14 | 0.15 | 0.15 | 0.13 | 0.14 | 0.15 | 0.15 | 0.14 | 0.13 | 0.15 | 0.15 |
| Cell No. | 91 | 92 | 93 | 94 | 95 | 96 | 97 | 98 | 99 | 100 | 101 | 102 | 103 | 104 | |
| Capacity /Ah | 89.41 | 89.25 | 90.12 | 89.05 | 89.62 | 89.41 | 89.25 | 88.98 | 88.75 | 89.32 | 89.62 | 89.41 | 89.25 | 89.66 | |
| Initial SOC | 0.15 | 0.14 | 0.14 | 0.15 | 0.14 | 0.15 | 0.15 | 0.13 | 0.14 | 0.15 | 0.15 | 0.15 | 0.15 | 0.14 | |

EP 4 564 028 A1

14

In step S6, calculate the actual SOC interval of each battery cell during the charging based on the initial SOC value $x_0^i$ and the initial capacity $Q_0^i$ of each battery cell.

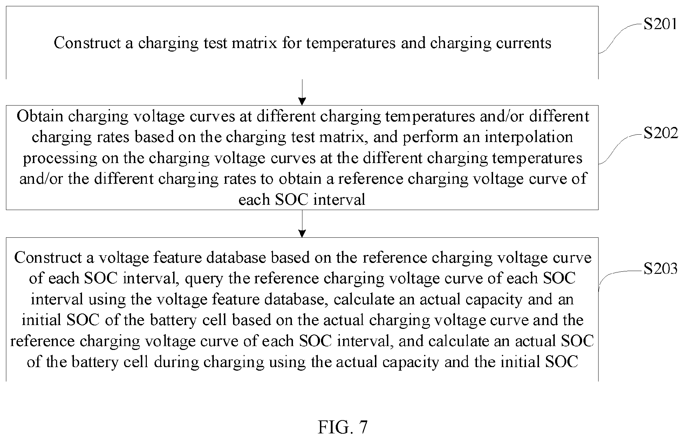

By substituting values of $x_0^i$ and $Q_0^i$ obtained at S5 into equation 8, the SOC upper limit of the battery cell numbered i during the actual charging can be calculated. The actual charging curve of each battery cell in the LFP battery pack is illustrated in FIG. 7.

With the method for estimating the SOC of the battery cell according to the embodiments of the present disclosure, the actual capacity and the initial SOC of the battery cell can be accurately calculated through the comparison between the actual charging voltage curve and the corresponding reference charging voltage curve of the battery cell, and the actual SOC of the battery cell during charging is calculated using the actual capacity and the initial SOC. Since the pre-calibrated standard reference charging voltage curve is used, the actual capacity of the battery cell can be accurately obtained through the comparison based on the voltage curve, which prevents the battery system from affecting the estimation result and is effectively applicable to the plurality of battery systems. In addition, the estimation method can be deployed on the server, in such a manner that the calculation efficiency is improved using computing resources of the server. The root-mean-square error can be calculated using the actual charging voltage curve and the reference charging voltage curve. The objective function is determined using the root-mean-square error. The actual capacity and the initial SOC of the battery cell is calculated using the least squares method to facilitate the subsequent calculation of the actual SOC of the battery cell during the charging. The total charging duration of the reference battery cell can be divided into the different charging stages. The interval identifiers are set for the SOC intervals in the different charging stages. The mathematical expressions for the different SOC intervals are established. Further, the actual charging voltage curve and the corresponding reference charging voltage curve are extracted using the mathematical expression. The root-mean-square error is calculated based on the respective mathematical expression of the actual charging voltage curve and the reference charging voltage curve of each SOC interval. The charging test matrix can be constructed from the two dimensions of temperature and charging current. The interpolation processing is performed on the charging voltage curves at the different charging temperatures and the different charging rates that are obtained using the charging matrix to obtain the plurality of reference charging voltage curves. The voltage feature database is constructed using the plurality of reference charging voltage curves and the SOC intervals to facilitate the subsequent lookup of the corresponding reference charging voltage curves based on the SOC intervals. The interpolation processing can be performed on the charging voltage curves at the different charging rates. The reference charging voltage curves corresponding to the charging voltage values under the any charging currents are calculated through the equation. The interpolation processing can be performed on the charging voltage curves at the different temperatures. The reference charging voltage curves corresponding to the voltage curves under the any temperature conditions are calculated through the equation.

FIG. 7 is a flowchart of a method for estimating a SOC of a battery cell according to another embodiment of the present disclosure.

As illustrated in FIG. 7, the method for estimating the SOC of the battery cell is applied in a server and includes following steps.

In step S201, construct a charging test matrix for temperatures and charging currents.

The method for constructing the charging test matrix has been described in the above embodiments, and thus details thereof will be omitted here.

In step S202, obtain charging voltage curves at different charging temperatures and/or different charging rates based on the charging test matrix, and perform an interpolation processing on the charging voltage curves at the different charging temperatures and/or the different charging rates to obtain a reference charging voltage curve of each SOC interval.

It should be understood that, in the embodiments of the present disclosure, the charging voltage curves at the different charging temperatures and the different charging rates can be obtained based on the charging test matrix. The interpolation processing is performed on the charging voltage curves at the different charging temperatures and the different charging rates to obtain the reference charging voltage curve of each SOC interval. The interpolation processing method has been described in the above embodiments, and thus details thereof will be omitted here.

In step S203, construct a voltage feature database based on the reference charging voltage curve of each SOC interval, query the reference charging voltage curve of each SOC interval using the voltage feature database, calculate an actual capacity and an initial SOC of the battery cell based on the actual charging voltage curve and the reference charging voltage curve of each SOC interval, and calculate an actual SOC of the battery cell during charging using the actual capacity and the initial SOC.

The voltage feature database stores the relationship between SOC intervals and reference charging voltage curves. The reference charging voltage curve corresponding to the SOC interval can be queried using the voltage feature database.

It should be understood that, in the embodiments of the present disclosure, the reference charging voltage curve of each SOC interval can be queried using the voltage feature database. The actual capacity and the initial SOC of the battery cell are calculated based on the actual charging voltage curve and the corresponding reference charging voltage curve of each SOC interval. The actual SOC corresponding to the battery cell during the charging is calculated using the actual capacity and the initial SOC. The specific calculation method has been described in the above embodiments, and thus details thereof will be omitted here.

With the method for estimating the SOC of the battery cell according to the embodiments of the present disclosure, the charging test matrix is constructed from the two dimensions of temperature and charging current. The charging voltage curves at the different charging temperatures and the different charging rates are obtained. The interpolation processing is performed on the charging voltage curves to obtain the reference charging voltage curves. The actual capacity and the initial SOC of the battery cell are calculated based on the actual charging voltage curve and the reference charging voltage curve of the battery cell within each SOC interval. The actual SOC corresponding to the battery cell during the charging is calculated using the actual capacity and the initial SOC. Therefore, the SOC is accurately calculated. In addition, the calculation method is deployed on the server, making it free from limitations related to complexity of the calculation method and voltage platform characteristics. As a result, the SOC value of each battery cell in the battery pack throughout an entire lifecycle of the battery cell can be accurately calculated.

An apparatus for estimating a SOC of a battery cell according to an embodiment of the present disclosure is described below with reference to the figures.

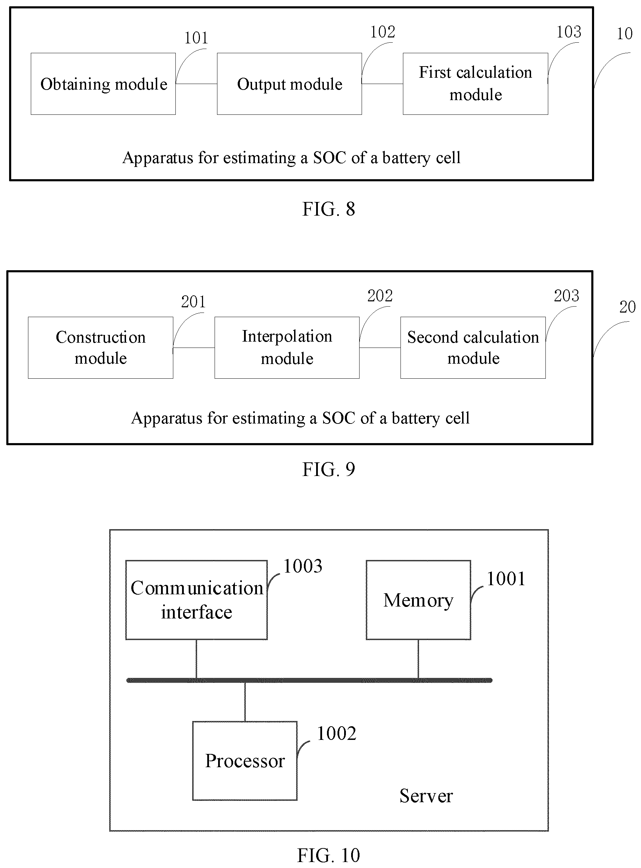

FIG. 8 is a block diagram showing an apparatus for estimating a SOC of a battery cell according to an embodiment of the present disclosure.

As illustrated in FIG. 8, an apparatus 10 for estimating a SOC of a battery cell is applied in a server and includes an obtaining module 101, an output module 102, and a first calculation module 103.

The obtaining module 101 is configured to obtain actual charging data of the battery cell within one or more SOC intervals. The output module 102 is configured to generate an actual charging voltage curve of each of the one or more SOC intervals based on actual charging data within each of the one or more SOC intervals, and query a pre-established voltage feature database using each of the one or more SOC intervals as an index to output a reference charging voltage curve of each of the one or more SOC intervals. The first calculation module 103 is configured to calculate an actual capacity and an initial SOC of the battery cell based on the actual charging voltage curve and the reference charging voltage curve of each of the one or more SOC intervals, and calculate an actual SOC of the battery cell during charging using the actual capacity and the initial SOC.

In an embodiment of the present disclosure, the first calculation module 103 is further configured to: calculate a root-mean-square error of the battery cell based on the actual charging voltage curve and the reference charging voltage curve of each of the one or more SOC intervals, and determine an objective function based on the root-mean-square error; and find an optimal solution to the objective function using a least squares method to obtain the actual capacity and the initial SOC of the battery cell.

In an embodiment of the present disclosure, the first calculation module 103 is further configured to: divide a total charging duration of a reference battery cell into different charging stages; add an interval identifier to a SOC interval corresponding to each of the different charging stages, and establish a mathematical expression for the SOC interval, the SOC, and a capacity based on the interval identifier; and extract the actual charging voltage curve and the corresponding reference charging voltage curve using the mathematical expression, and calculate the root-mean-square error of the battery cell based on respective mathematical expressions of the actual charging voltage curve and the reference charging voltage curve of each of the one or more SOC intervals.

In an embodiment of the present disclosure, the apparatus 10 of the present disclosure further includes a processing module.

The processing module is configured to, prior to the querying the pre-established voltage feature database: construct a charging test matrix for temperatures and charging currents; obtain charging voltage curves at different charging temperatures and/or different charging rates based on the charging test matrix, and perform an interpolation processing on the charging voltage curves at the different charging temperatures and/or the different charging rates to obtain a plurality of reference charging voltage curves; and construct, based on each of the one or more SOC intervals and the corresponding reference charging voltage curve, a voltage feature database.

In an embodiment of the present disclosure, the processing module is further configured to: calculate a maximum charging capacity corresponding to all the charging voltage curves at the different charging rates; determine a stepsize of a capacity interval corresponding to each of the charging voltage curves based on the maximum charging capacity, and divide the capacity interval into a plurality of grids based on the stepsize; and calculate a first constant based on a voltage value of each of the plurality of grids, obtain charging voltage values under any charging currents based on the first constant, and generate the plurality of reference charging voltage curves based on the charging voltage values under the any charging currents.

In an embodiment of the present disclosure, the processing module is further configured to: calculate a maximum charging capacity corresponding to all the charging voltage curves at the different charging temperatures; determine a stepsize of a capacity interval corresponding to each of the charging voltage curves based on the maximum charging capacity, and divide the capacity interval into a plurality of grids based on the stepsize; and calculate a second constant based on a voltage value of each of the plurality of grids, obtain voltage curves under any temperature conditions based on the second constant, and obtain the plurality of reference charging voltage curves based on the voltage curves under the any temperature conditions.

In an embodiment of the present disclosure, the processing module is further configured to: at a predetermined temperature, perform constant current discharge with a first predetermined current until reaching a predetermined cut-off voltage, perform, by switching to a second predetermined current, constant current discharge with the second predetermined current until reaching the predetermined cut-off voltage, let stand for a first predetermined duration, perform constant current charge with a third predetermined current until reaching the predetermined cut-off voltage, and record a charging voltage curve at a current charging temperature and/or a current charging rate; and let stand for a second predetermined duration, perform constant current discharge with a fourth predetermined current until reaching the predetermined cut-off voltage, perform, by switching to a fifth predetermined current, constant current discharge with the fifth predetermined current until reaching the predetermined cut-off voltage, let stand for a third predetermined duration, and re-perform a charging test at another charging rate and/or another charging temperature.

It should be noted that the above explanatory description of the embodiments of the method for estimating the SOC of the battery cell is also applicable to the apparatus for estimating the SOC of the battery cell according to this embodiment, and thus details thereof will be omitted here.

With the apparatus for estimating the SOC of the battery cell according to the embodiments of the present disclosure, the actual capacity and the initial SOC of the battery cell can be accurately calculated through the comparison between the actual charging voltage curve of the battery cell and the corresponding reference charging voltage curve, and the actual SOC of the battery cell during the charging is calculated using the actual capacity and the initial SOC. Since the pre-calibrated standard reference charging voltage curve is used, the actual capacity of the battery cell can be accurately obtained through the comparison based on the voltage curve, which prevents the battery system from affecting the estimation result and is effectively applicable to the plurality of battery systems. In addition, the estimation method can be deployed on the server, in such a manner that the calculation efficiency is improved using computing resources of the server. The root-mean-square error can be calculated using the actual charging voltage curve and the reference charging voltage curve. The objective function is determined using the root-mean-square error. The actual capacity and the initial SOC of the battery cell is calculated using the least squares method to facilitate the subsequent calculation of the actual SOC of the battery cell during the charging. The total charging duration of the reference battery cell can be divided into the different charging stages. The interval identifiers are set for the SOC intervals in the different charging stages. The mathematical expressions for the different SOC intervals are established. Further, the actual charging voltage curve and the corresponding reference charging voltage curve are extracted using the mathematical expression. The root-mean-square error is calculated based on the respective mathematical expression of the actual charging voltage curve and the reference charging voltage curve of each SOC interval. The charging test matrix can be constructed from the two dimensions of temperature and charging current. The interpolation processing is performed on the charging voltage curves at the different charging temperatures and the different charging rates that are obtained using the charging matrix to obtain the plurality of reference charging voltage curves. The voltage feature database is constructed using the plurality of reference charging voltage curves and the SOC intervals to facilitate the subsequent lookup of the corresponding reference charging voltage curves based on the SOC intervals. The interpolation processing can be performed on the charging voltage curves at the different charging rates. The reference charging voltage curves corresponding to the charging voltage values under the any charging currents are calculated through the equation. The interpolation processing can be performed on the charging voltage curves at the different temperatures. The reference charging voltage curves corresponding to the voltage curves under the any temperature conditions are calculated through the equation.

FIG. 9 is a block diagram showing an apparatus for estimating a SOC of a battery cell according to another embodiment of the present disclosure.

As illustrated in FIG. 9, an apparatus 20 for estimating a SOC of a battery cell is applied in a server and includes a construction module 201, an interpolation module 202, and a second calculation module 203.

The construction module 201 is configured to construct a charging test matrix for temperatures and charging currents. The interpolation module 202 is configured to: obtain charging voltage curves at different charging temperatures and/or different charging rates based on the charging test matrix, and perform an interpolation processing on the charging voltage curves at the different charging temperatures and/or the different charging rates to obtain a reference charging voltage curve of each SOC interval. The second calculation module 203 is configured to: construct a voltage feature database based on the reference charging voltage curve of each SOC interval, query the reference charging voltage curve of each SOC interval using the voltage feature database, calculate an actual capacity and an initial SOC of the battery cell based on the actual charging voltage curve and the reference charging voltage curve of each SOC interval, and calculate an actual SOC of the battery cell during charging using the actual capacity and the initial SOC.

It should be noted that the above explanatory description of the embodiments of the method for estimating the SOC of the battery cell is also applicable to the apparatus for estimating the SOC of the battery cell according to this embodiment, and thus details thereof will be omitted here.

With the apparatus for estimating the SOC of the battery cell according to the embodiments of the present disclosure, the charging test matrix is constructed from the two dimensions of temperature and charging current. The charging voltage curves at the different charging temperatures and the different charging rates are obtained. The interpolation processing is performed on the charging voltage curves to obtain the reference charging voltage curves. The actual capacity and the initial SOC of the battery cell are calculated based on the actual charging voltage curve and the reference charging voltage curve of the battery cell within each SOC interval. The actual SOC corresponding to the battery cell during the charging is calculated using the actual capacity and the initial SOC. Therefore, the SOC is accurately calculated. In addition, the calculation method is deployed on the server, making it free from limitations related to complexity of the calculation method and the voltage platform characteristics. As a result, the SOC value of each battery cell in the battery pack throughout the entire lifecycle of the battery cell can be accurately calculated.

FIG. 10 is a block diagram showing a structure of a server according to an embodiment of the present disclosure. The server may include a memory 1001; a processor 1002; and a computer program stored in the memory 1001 and executable on the processor 1002.

The processor 1002, when executing the computer program, implements the method for estimating the SOC of the battery cell according to the above embodiments.

Further, the server further includes a communication interface 1003 configured for a communication between the memory 1001 and the processor 1002.

The memory 1001 is configured to store a computer program executable by the processor 1002.

The memory 1001 may include a high-speed Random Access Memory, RAM, and may also include a non-volatile memory, such as at least one disk memory.

When the memory 1001, the processor 1002, and the communication interface 1003 are implemented independently, the communication interface 1003, the memory 1001, and the processor 1002 can be connected to each other via a bus and communicate with each other. The bus can be an Industry Standard Architecture, ISA, bus, a Peripheral Component, PCI, bus, or an Extended Industry Standard Architecture, EISA, bus, etc. The bus can be categorized into an address bus, a data bus, a control bus, etc. For ease of representation, only one thick line is used in FIG. 10, but it does not mean that there is only one bus or one type of bus.

Optionally, in a specific implementation, when the memory 1001, the processor 1002, and the communication interface 1003 are integrated on a single chip, the memory 1001, the processor 1002, and the communication interface 1003 can communicate with each other via an internal interface.

The processor 1002 can be a Central Processing Unit, CPU, an Application Specific Integrated Circuit, ASIC, or one or more integrated circuits configured to implement the embodiments of the present disclosure.

A computer-readable storage medium is further provided according to an embodiment of the present disclosure. The computer-readable storage medium stores a computer program. The computer program, when executed by a processor, implements the method for estimating the SOC of the battery cell as described above.

Reference throughout this specification to "an embodiment", "some embodiments", "an example", "a specific example", or "some examples" means that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Further, the particular features, structures, materials, or characteristics may be combined in any suitable manner in one or N embodiments or examples. In addition, different embodiments or examples and features of different embodiments or examples described in the specification may be combined by those skilled in the art without mutual contradiction.

In addition, the terms "first" and "second" are only used for descriptive purposes, and cannot be understood as indicating or implying relative importance or implicitly indicating the number of indicated technical features. Therefore, the features associated with "first" and "second" may explicitly or implicitly include at least one of the features. In the description of the present disclosure, "N" means at least two, such as two, three, etc., unless otherwise specifically defined.

Any process or method described in a flowchart or described herein in other ways may be understood to include one or N modules, segments, or portions of codes of executable instructions for achieving specific logical functions or steps in the process. The scope of a preferred embodiment of the present disclosure includes other implementations. A function may be performed not in a sequence shown or discussed, including a substantially simultaneous manner or a reverse sequence based on the function involved, which should be understood by those skilled in the art to which the embodiments of the present disclosure belong.

It should be understood that each part of the present disclosure may be realized by hardware, software, firmware, or a combination thereof. In the above embodiments, N steps or methods may be realized by software or firmware stored in the memory and executed by an appropriate instruction execution system. For example, when it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a Programmable Gate Array, a Field Programmable Gate Array, etc.

It should be understood by those skilled in the art that all or a part of the steps carried by the method in the above-described embodiments may be completed by relevant hardware instructed by a program. The program may be stored in a computer-readable storage medium. When the program is executed, one or a combination of the steps of the method in the above-described embodiments may be included.

**Claims**

1. A method for estimating a State of Charge, SOC, of a battery cell, the method being applied in a server, wherein the method comprises:

   obtaining actual charging data of the battery cell within one or more SOC intervals;
   generating an actual charging voltage curve of each of the one or more SOC intervals based on the actual charging data within each of the one or more SOC intervals, and querying a pre-established voltage feature database using each of the one or more SOC intervals as an index to output a reference charging voltage curve of each of the one or more SOC intervals; and
   calculating an actual capacity and an initial SOC of the battery cell based on the actual charging voltage curve and the reference charging voltage curve of each of the one or more SOC intervals, and calculating an actual SOC of the battery cell during charging using the actual capacity and the initial SOC.

2. The method for estimating the SOC of the battery cell according to claim 1, wherein said calculating the actual capacity and the initial SOC of the battery cell based on the actual charging voltage curve and the reference charging voltage curve of each of the one or more SOC intervals comprises:

   calculating a root-mean-square error of the battery cell based on the actual charging voltage curve and the reference charging voltage curve of each of the one or more SOC intervals, and determining an objective function based on the root-mean-square error; and
   finding an optimal solution to the objective function using a least squares method to obtain the actual capacity and the initial SOC of the battery cell.

3. The method for estimating the SOC of the battery cell according to claim 2, wherein said calculating the root-mean-square error of the battery cell based on the actual charging voltage curve and the reference charging voltage curve of each of the one or more SOC intervals comprises:

   dividing a total charging duration of a reference battery cell into different charging stages;
   adding an interval identifier to a SOC interval corresponding to each of the different charging stages, and establishing a mathematical expression for the SOC interval, the SOC, and a capacity based on the interval identifier; and
   extracting the actual charging voltage curve and the corresponding reference charging voltage curve using the mathematical expression, and calculating the root-mean-square error of the battery cell based on respective mathematical expressions of the actual charging voltage curve and the reference charging voltage curve of each of the one or more SOC intervals.

4. The method for estimating the SOC of the battery cell according to claim 1, further comprising, prior to said querying the pre-established voltage feature database:

   constructing a charging test matrix for temperatures and charging currents;
   obtaining charging voltage curves at different charging temperatures and/or different charging rates based on the charging test matrix, and performing an interpolation processing on the charging voltage curves at the different charging temperatures and/or the different charging rates to obtain a plurality of reference charging voltage curves; and
   constructing, based on each of the one or more SOC intervals and the corresponding reference charging voltage curve, a voltage feature database.

5. The method for estimating the SOC of the battery cell according to claim 4, wherein said performing the interpolation processing on the charging voltage curves at the different charging temperatures and/or the different charging rates to obtain the plurality of reference charging voltage curves comprises:

calculating a maximum charging capacity corresponding to all the charging voltage curves at the different charging rates;
determining a stepsize of a capacity interval corresponding to each of the charging voltage curves based on the maximum charging capacity, and dividing the capacity interval into a plurality of grids based on the stepsize; and calculating a first constant based on a voltage value of each of the plurality of grids, obtaining charging voltage values under any charging currents based on the first constant, and generating the plurality of reference charging voltage curves based on the charging voltage values under the any charging currents.

6. The method for estimating the SOC of the battery cell according to claim 4, wherein said performing the interpolation processing on the charging voltage curves at the different charging temperatures and/or the different charging rates to obtain the plurality of reference charging voltage curves comprises:

calculating a maximum charging capacity corresponding to all the charging voltage curves at the different charging temperatures;
determining a stepsize of a capacity interval corresponding to each of the charging voltage curves based on the maximum charging capacity, and dividing the capacity interval into a plurality of grids based on the stepsize; and calculating a second constant based on a voltage value of each of the plurality of grids, obtaining voltage curves under any temperature conditions based on the second constant, and obtaining the plurality of reference charging voltage curves based on the voltage curves under the any temperature conditions.

7. The method for estimating the SOC of the battery cell according to claim 4, wherein said obtaining the charging voltage curves at the different charging temperatures and/or the different charging rates based on the charging test matrix comprises:

at a predetermined temperature, performing constant current discharge with a first predetermined current until reaching a predetermined cut-off voltage, performing, by switching to a second predetermined current, constant current discharge with the second predetermined current until reaching the predetermined cut-off voltage, letting stand for a first predetermined duration, performing constant current charge with a third predetermined current until reaching the predetermined cut-off voltage, and recording a charging voltage curve at a current charging temperature and/or a current charging rate; and
letting stand for a second predetermined duration, performing constant current discharge with a fourth predetermined current until reaching the predetermined cut-off voltage, performing, by switching to a fifth predetermined current, constant current discharge with the fifth predetermined current until reaching the predetermined cut-off voltage, letting stand for a third predetermined duration, and re-performing a charging test at another charging rate and/or another charging temperature.

8. A method for estimating a State of Charge, SOC, of a battery cell, the method being applied in a server, wherein the method comprises:

constructing a charging test matrix for temperatures and charging currents;
obtaining charging voltage curves at different charging temperatures and/or different charging rates based on the charging test matrix, and performing an interpolation processing on the charging voltage curves at the different charging temperatures and/or the different charging rates to obtain a reference charging voltage curve of each SOC interval; and
constructing a voltage feature database based on the reference charging voltage curve of each SOC interval, querying the reference charging voltage curve of each SOC interval using the voltage feature database, calculating an actual capacity and an initial SOC of the battery cell based on the actual charging voltage curve and the reference charging voltage curve of each SOC interval, and calculating an actual SOC of the battery cell during charging using the actual capacity and the initial SOC.

9. An apparatus for estimating a State of Charge, SOC, of a battery cell, the apparatus being applied in a server, wherein the apparatus comprises:

an obtaining module configured to obtain actual charging data of the battery cell within one or more SOC intervals;
an output module configured to: generate an actual charging voltage curve of each of the one or more SOC intervals based on actual charging data within each of the one or more SOC intervals, and query a pre-established voltage feature database using each of the one or more SOC intervals as an index to output a reference charging voltage curve of each of the one or more SOC intervals; and

a first calculation module configured to: calculate an actual capacity and an initial SOC of the battery cell based on the actual charging voltage curve and the reference charging voltage curve of each of the one or more SOC intervals, and calculate an actual SOC of the battery cell during charging using the actual capacity and the initial SOC.

10. An apparatus for estimating a State of Charge, SOC, of a battery cell, the apparatus being applied in a server, wherein the apparatus comprises:

a construction module configured to construct a charging test matrix for temperatures and charging currents;

an interpolation module configured to: obtain charging voltage curves at different charging temperatures and/or different charging rates based on the charging test matrix, and perform an interpolation processing on the charging voltage curves at the different charging temperatures and/or the different charging rates to obtain a reference charging voltage curve of each SOC interval; and

a second calculation module configured to: construct a voltage feature database based on the reference charging voltage curve of each SOC interval, query the reference charging voltage curve of each SOC interval using the voltage feature database, calculate an actual capacity and an initial SOC of the battery cell based on the actual charging voltage curve and the reference charging voltage curve of each SOC interval, and calculate an actual SOC of the battery cell during charging using the actual capacity and the initial SOC.

11. A server, comprising:

a memory;

a processor; and

a computer program stored in the memory and executable on the processor,

wherein the processor, when executing the computer program, implements the method for estimating the SOC of the battery cell according to any one of claims 1 to 8.

12. A computer-readable storage medium having a computer program stored thereon, wherein the computer program, when executed by a processor, implements the method for estimating the SOC of the battery cell according to any one of claims 1 to 8.

Obtain actual charging data of the battery cell within one or more SOC intervals ⌐S101

Generate an actual charging voltage curve of each of the one or more SOC intervals based on the actual charging data within each of the one or more SOC intervals, and query a pre-established voltage feature database using each of the one or more SOC intervals as an index to output a reference charging voltage curve of each of the one or more SOC intervals ⌐S102

Calculate an actual capacity and an initial SOC of the battery cell based on the actual charging voltage curve and the reference charging voltage curve of each of the one or more SOC intervals, and calculate an actual SOC of the battery cell during charging using the actual capacity and the initial SOC ⌐S103

FIG. 1

FIG. 2

| | |
|---|---|
| Construct feature database $V=f(I,T,x)$ of a LFP battery cell related to charging voltages, currents, temperatures, and SOCs | S1 |
| Divide the total charging duration into different charging stages $t_1$, $t_2$, $t_3$, $t_4$, … based on a numerical change of the actual charging current of the battery, and label SOC intervals corresponding to different charging stages of each battery cell as $\theta_1^i$, $\theta_2^i$, $\theta_3^i$, $\theta_4^i$, … | S2 |
| Establish mathematical expressions for the different SOC intervals $\theta_1^i$, $\theta_2^i$, $\theta_3^i$, $\theta_4^i$, … | S3 |
| Extract actual charging voltage curves $V_1^i(\theta_1^i), V_2^i(\theta_2^i), V_3^i(\theta_3^i), V_4^i(\theta_4^i)$, … corresponding to each battery cell (i) in different charging SOC intervals | S4 |
| Query a standard voltage curve through the feature database $V=f(I,T,x)$, determine a root-mean-square error between each of $V_1^i(\theta_1^i), V_2^i(\theta_2^i), V_3^i(\theta_3^i), V_4^i(\theta_4^i)$, … and the standard voltage curve as the objective function, and calculate the actual capacity $Q_0^i$ and the initial SOC $x_0^i$ of each battery cell using the least squares method | S5 |
| Calculate the actual SOC interval of each battery cell during the charging based on the initial SOC value $x_0^i$ and the initial capacity $Q_0^i$ of each battery cell | S6 |

FIG. 3

FIG. 4

FIG. 5

FIG. 6

Construct a charging test matrix for temperatures and charging currents ⟋S201

Obtain charging voltage curves at different charging temperatures and/or different charging rates based on the charging test matrix, and perform an interpolation processing on the charging voltage curves at the different charging temperatures and/or the different charging rates to obtain a reference charging voltage curve of each SOC interval ⟋S202

Construct a voltage feature database based on the reference charging voltage curve of each SOC interval, query the reference charging voltage curve of each SOC interval using the voltage feature database, calculate an actual capacity and an initial SOC of the battery cell based on the actual charging voltage curve and the reference charging voltage curve of each SOC interval, and calculate an actual SOC of the battery cell during charging using the actual capacity and the initial SOC ⟋S203

FIG. 7

FIG. 8

FIG. 9

FIG. 10

## INTERNATIONAL SEARCH REPORT

| | International application No. |
|---|---|
| | **PCT/CN2023/120810** |

**A.    CLASSIFICATION OF SUBJECT MATTER**

G01R31/367(2019.01)i;  G01R31/36(2020.01)i;  G01R31/396(2019.01)i;  G01R31/388(2019.01)i

According to International Patent Classification (IPC) or to both national classification and IPC

**B.    FIELDS SEARCHED**

Minimum documentation searched (classification system followed by classification symbols)

IPC：G01R

Documentation searched other than minimum documentation to the extent that such documents are included in the fields searched

Electronic data base consulted during the international search (name of data base and, where practicable, search terms used)

CNABS; CNTXT; CNKI; VEN; WOTXT; USTXT; EPTXT; IEEE: 深蓝汽车, 李东江, 李宗华, 电池, 容量, 电压, 充电, 放电, 曲线, 标准, 参考, 出厂, 初始, 荷电状态, 剩余电量, SOC, state of charge, batter+, capacity, voltage, charg+, discharg+, curve, standard, reference, initial

**C.    DOCUMENTS CONSIDERED TO BE RELEVANT**

| Category* | Citation of document, with indication, where appropriate, of the relevant passages | Relevant to claim No. |
|---|---|---|
| PX | CN 116430243 A (DEEPAL AUTOMOBILE TECHNOLOGY CO., LTD.) 14 July 2023 (2023-07-14) claims 1-12, and description, paragraphs [0005]-[0039] | 1-12 |
| PX | CN 116430242 A (DEEPAL AUTOMOBILE TECHNOLOGY CO., LTD.) 14 July 2023 (2023-07-14) description, paragraphs [0053]-[0175] | 1-12 |
| PX | CN 116718922 A (DEEPAL AUTOMOBILE TECHNOLOGY CO., LTD.) 08 September 2023 (2023-09-08) description, paragraphs [0062]-[0225] | 1-12 |
| A | CN 103399278 A (TSINGHUA UNIVERSITY) 20 November 2013 (2013-11-20) description, paragraphs [0044]-[0076] | 1-12 |
| A | CN 112379291 A (ZHEJIANG NARADA POWER SOURCE CO., LTD. et al.) 19 February 2021 (2021-02-19) entire document | 1-12 |

☑ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **07 December 2023** | **11 December 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/120810** |

### C.    DOCUMENTS CONSIDERED TO BE RELEVANT

| Category* | Citation of document, with indication, where appropriate, of the relevant passages | Relevant to claim No. |
| --- | --- | --- |
| A | US 2019277917 A1 (THE HKUST FOK YING TUNG RESEARCH INSTITUTE) 12 September 2019 (2019-09-12)<br>entire document | 1-12 |
| A | US 2018031642 A1 (HYUNDAI MOTOR CO., LTD. et al.) 01 February 2018 (2018-02-01)<br>entire document | 1-12 |
| A | KR 20210037263 A (KOREA ELECTRIC POWER CORP. et al.) 06 April 2021 (2021-04-06)<br>entire document | 1-12 |

Form PCT/ISA/210 (second sheet) (July 2022)

## INTERNATIONAL SEARCH REPORT
### Information on patent family members

International application No.

**PCT/CN2023/120810**

| Patent document cited in search report | | | Publication date (day/month/year) | Patent family member(s) | | | Publication date (day/month/year) |
|---|---|---|---|---|---|---|---|
| CN | 116430243 | A | 14 July 2023 | None | | | |
| CN | 116430242 | A | 14 July 2023 | None | | | |
| CN | 116718922 | A | 08 September 2023 | None | | | |
| CN | 103399278 | A | 20 November 2013 | CN | 103399278 | B | 23 March 2016 |
| CN | 112379291 | A | 19 February 2021 | None | | | |
| US | 2019277917 | A1 | 12 September 2019 | US | 11067634 | B2 | 20 July 2021 |
| US | 2018031642 | A1 | 01 February 2018 | US | 10168390 | B2 | 01 January 2019 |
| KR | 20210037263 | A | 06 April 2021 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310640947